# EUROPEAN PATENT APPLICATION

(11) **EP 2 503 793 A1**
(43) Date of publication of application: **26.09.2012**
(21) Application number: 10831693.6
(22) Date of filing: 11.02.2010
(51) Int. Cl.: H04R 19/04, H04R 31/00

(54) **MEMS MICROPHONE PACKAGE AND PACKAGING METHOD**

(30) Priority: 18.11.2009 KR 20090111206
(71) Applicant: BSE Co., Ltd., Incheon 405-817 (KR)
(72) Inventor: SONG, Chung-Dam, Seoul 157-010 (KR); KIM, Chang-Won, Incheon 405-220 (KR); KIM, Jung-Min, Incheon 406-112 (KR); LEE, Won-Taek, Incheon 406-110 (KR); PARK, Sung-Ho, Incheon 407-330 (KR)
(74) Representative: Mollekopf, Gerd Willi
(86) International application number: PCT/KR2010/000877
(87) International publication number: WO 2011/062325

(57) **Abstract**

The present invention relates to a MEMS microphone package having improved acoustic properties, and to a packaging method, which involve adding a vent path in the packaging process to improve equilibrium between internal and external air pressure. The MEMS microphone package of the present invention comprises: a MEMS microphone chip having a back plate and a diaphragm formed on a silicon body using MEMS fabrication technology; a substrate on which the MEMS microphone chip is mounted; a bonded portion formed by applying an adhesive onto the substrate excluding one portion, and then bonding the MEMS microphone chip body to the substrate, so as to form a vent path between the MEMS microphone chip body and the substrate; and a case bonded to the substrate so as to define a space for housing the MEMS microphone chip. Equilibrium between internal and external air pressure of the MEMS microphone chip is achieved by means of the vent path, thereby improving acoustic properties.

## Description

### Technical Field

The present invention relates to a micro electro machining system (MEMS) microphone package, and more particularly, to an MEMS microphone package of which acoustic properties are improved by improving air equilibrium between inner air pressure and outer air pressure by adding a vent path during a packaging process and a method of packaging the MEMS microphone package.

### Background Art

Since researches on micro electro machining system (MEMS) microphones have been first reported by R. Hijab, et al. in the 1980s, researches have been made on various structures of microphones using MEMS process techniques and techniques for manufacturing the same. An MEMS process is based on semiconductor process techniques. Through the MEMS process, a thin-film with stable and adjustable material properties may be fabricated, batch process may be possible, and a small, inexpensive, and highly efficient microphone chip may be embodied. Furthermore, compared to a conventional electret condenser microphone, an MEMS microphone may be assembled and operated at a relatively high temperature, and thus, an MEMS microphone package may be assembled by using existing surface mounting devices (SMD) and techniques.

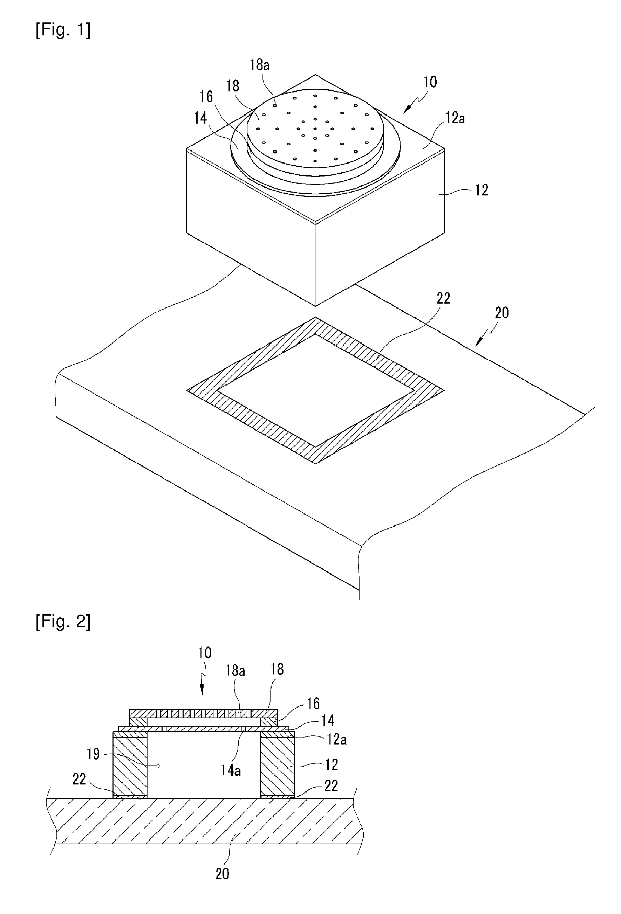

Generally, as shown in FIGS. 1 and 2, an MEMS microphone package is assembled by embodying an MEMS microphone chip 10 having a back plate and a diaphragm structure by using a silicon substrate and attaching the MEMS microphone chip 10 to a printed circuit board (PCB) 20 via an adhesive 22.

Referring to FIGS. 1 and 2, the MEMS microphone chip 10 is fabricated by forming an insulation layer 12a on a body 12 of a monocrystalline silicon by using silicon bulk micromachining technique, embodying a back chamber 19 and a diaphragm 14 by anisotropically wet-etching or dry-etching the insulation layer 12a, embodying a back plate 18, which is supported by a spacer ring 16 and has a plurality of sound holes 18a, by using a sacrificing layer by using silicon surface micromachining technique, and forming vent holes 14a in the diaphragm 14 for air equilibrium of the MEMS microphone 10. Next, as shown in FIG. 1, the MEMS microphone chip 10 is packaged by applying the adhesive 22 to the PCB 20 to adhere the entire MEMS microphone chip 10, attaching the MEMS microphone chip 10 to the PCB 20, and drying the adhesive 22.

### Disclosure of the Invention

### Technical Problem

When a MEMS microphone chip is fabricated, a plurality of vent holes are formed in a diaphragm to maintain air equilibrium between inner air pressure and outer air pressure. However, due to technical limits of manufacturing technologies, if an excessive number of vent holes are formed in a diaphragm or diameter of a vent hole is excessive, capacitances formed by surface areas of a back plate and a diaphragm decrease, and thus, sensitivity of the diaphragm is deteriorated. As a result, characteristics of low frequency domain are deteriorated. On the contrary, if an insufficient number of vent holes are formed in a diaphragm or diameter of a vent hole is insufficient, sensitivity of the diaphragm is improved, but air equilibrium is insufficient. Therefore, air resistance is formed in a back chamber, and thus, abnormalities occur in response speed and sensitivity of the diaphragm.

The present invention provides a micro electro machining system (MEMS) microphone package of which acoustic properties are improved by improving air equilibrium between inner air pressure and outer air pressure by adding a vent path during attachment of an MEMS microphone chip and a method of packaging the MEMS microphone package.

### Technical Solution

According to an aspect of the present invention, there is provided a micro electro machining system (MEMS) microphone package including a MEMS microphone chip, in which a back plate and a diaphragm structure are formed in a body by using MEMS process techniques; a substrate for mounting the MEMS microphone chip thereon; a vent path which is formed between the MEMS microphone chip and the substrate by applying an adhesive only to a portion of the substrate and adhering the MEMS microphone chip to the substrate; and a case which is adhered to the substrate and forms a space for accommodating the MEMS microphone chip, wherein acoustic properties of the MEMS microphone package are improved as air pressure inside the MEMS microphone chip and air pressure outside the MEMS microphone chip form air equilibrium via the vent path.

According to another aspect of the present invention, there is provided a method of packaging a MEMS microphone, the method including preparing a substrate; calculating a thickness of an adhesive to be applied to the substrate; applying the adhesive to a portion of the substrate to the calculated thickness, such that the adhesive is not applied to a portion in which a vent path is to be formed; adhering an MEMS microphone chip to the adhesive; drying the adhesive; and adhering a case to the sub strate.

The substrate is any of a printed circuit board (PCB), a ceramic substrate, and a metal substrate, and sound holes are formed in any one of the case and the substrate.

### Advantageous Effects

An MEMS microphone package according to an embodiment of the present invention may have improved acoustic properties by overcoming limits of manufacturing an MEMS microphone chip by adding a vent path when an MEMS microphone is attached to a substrate. In other words, an MEMS microphone package according to the an embodiment of the present invention may maintain air equilibrium between inner air pressure and outer air pressure stably regardless of vent holes of an MEMS microphone chip, and thus, abnormalities may be prevented without deteriorating the sensitivity of a diaphragm.

### Brief Description of the Drawings

FIG. 1 is a schematic diagram showing an example of attaching a micro electro machining system (MEMS) chip to a printed circuit board (PCB) in the related art;
FIG. 2 is a lateral sectional view of the example of attaching the MEMS chip to the PCB in the related art;
FIG. 3 is a schematic diagram showing an example of attaching an MEMS microphone chip to a PCB according to an embodiment of the present invention;
FIG. 4 is a lateral sectional view of the example of attaching the MEMS microphone chip to the PCB;
FIG. 5 is a flowchart showing a method of packaging an MEMS microphone chip according to an embodiment of the present invention;
FIG. 6 is a diagram showing an example of an MEMS microphone package, in which sound holes are formed in a case; and
FIG. 7 shows an example of an MEMS microphone package according to another embodiment of the present invention, where sound holes are formed in a sub strate.

### Best mode for carrying out the Invention

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete.

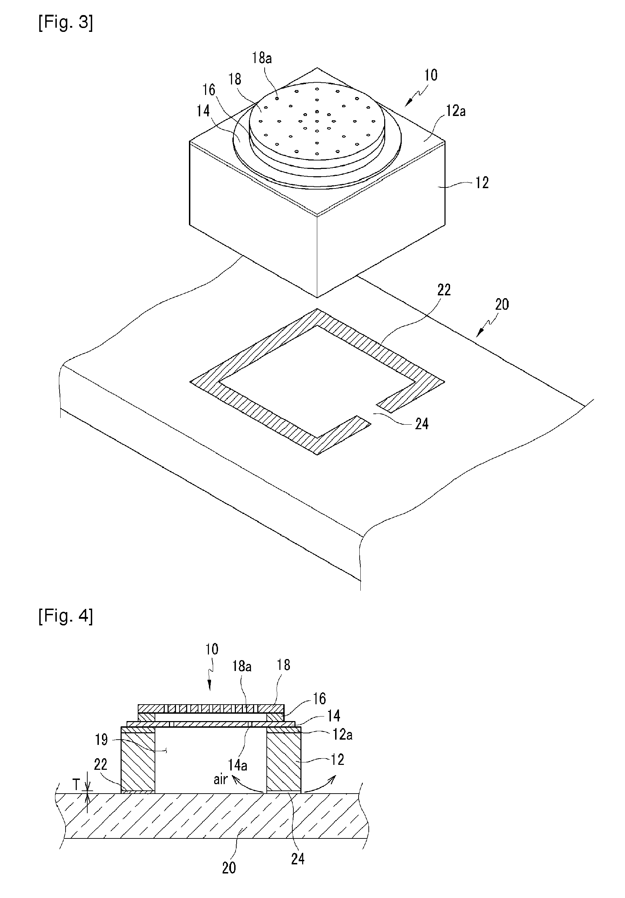

FIG. 3 is a schematic diagram showing an example of attaching a micro electro machining system (MEMS) microphone chip 10 to a printed circuit board (PCB) 20 according to an embodiment of the present invention, and FIG. 4 is a lateral sectional view of the example of attaching the MEMS microphone chip 10 to the PCB 20.

As shown in FIGS. 3 and 4, an MEMS microphone package according to an embodiment of the present invention is assembled by embodying the MEMS microphone chip 10 having a back plate and a diaphragm structure by using a silicon substrate and attaching the MEMS microphone chip 10 to the PCB 20 via an adhesive 22, wherein the adhesive 22 is partially applied to form an empty space to form a vent path 24 for maintaining air equilibrium between inner air pressure and outer air pressure.

Referring to FIGS. 3 and 4, the MEMS microphone chip 10 according to the present embodiment is manufactured by forming an insulation layer 12a on top of a body 12 of monocrystalline silicon by using silicon bulk micromachining technique, embodying a back chamber 19 and a diaphragm 14 by anisotropically wet-etching or dry-etching the insulation layer 12a, forming a back plate 18, which is supported by a spacer ring 16, by using a sacrificing layer by using a silicon surface micromachining technique, and forming vent holes 14a in the diaphragm 14 for air equilibrium of the MEMS microphone 10. Here, via holes 18a are formed in the back plate 18, whereas the vent holes 14a are formed in the diaphragm 14, so that air equilibrium is formed between air pressure inside the diaphragm 14 and air pressure outside the diaphragm 14.

Furthermore, as shown in FIG. 3, in the MEMS microphone package according to the present embodiment, the adhesive 22 is applied to only portions of surfaces of the MEMS microphone chip 10 and the PCB 20 to form an empty space to form a vent path 24. Therefore, after the MEMS microphone chip 10 is attached to the PCB 4, the vent path 24 is formed in a portion where the adhesive 22 is not applied, as shown in FIG. 4. The PCB 20 may be formed of a PCB material, a ceramic, or a metal, and a thickness T of the applied adhesive 22 may be from several µm to dozens of µm, which causes no change in frequency characteristics.

Therefore, an MEMS microphone package according to the present embodiment may maintain air equilibrium between inner air pressure and outer air pressure stably regardless of vent holes of the MEMS microphone chip 10, and thus, abnormalities may be prevented without deteriorating the sensitivity of the diaphragm 14.

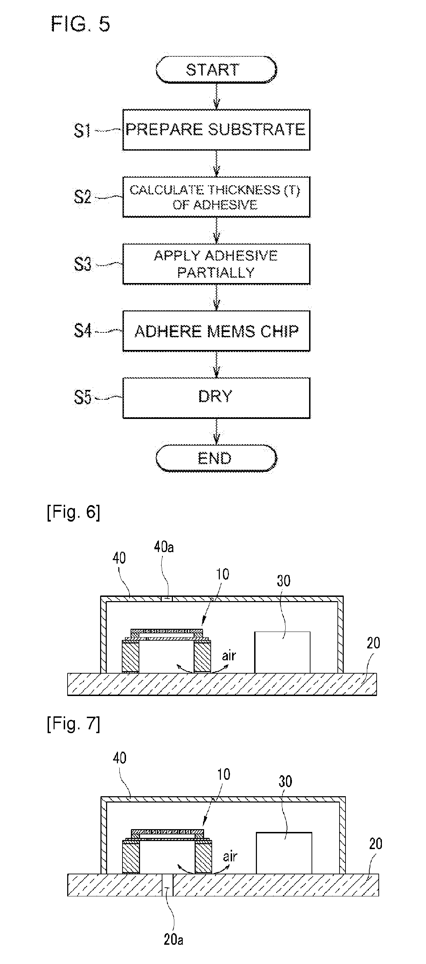

FIG. 5 is a flowchart showing a method of packaging an MEMS microphone chip according to an embodiment of the present invention.

As shown in FIG. 5, the method of packaging an MEMS microphone chip according to the present embodiment includes preparing the PCB 20, calculating a thickness T of the adhesive 22, which causes no change in frequency characteristics, and applying the adhesive 22 to the PCB 20 to the calculated thickness T, attaching the MEMS microphone chip 10 to the adhesive 22, and drying the adhesive 22 (operations S1 through S5). Next, other circuit devices 30 for driving the MEMS microphone chip 10 and processing signals are mounted on the PCB 20, and then the PCB 20 is attached to a case 40. Accordingly, a space for accommodating the MEMS microphone chip 10 and the mounted circuit devices 30 is formed.

FIG. 6 is a diagram showing an example of an MEMS microphone package, in which sound holes are formed in a case, according to an embodiment of the present invention. In detail, according to the present embodiment, the vent path 24 is formed by applying the adhesive 22 only to portions of surfaces of the PCB 20 and the MEMS microphone chip 10 to be adhered to each other, and then the case 40 in which sound holes 40a are formed is adhered to the PCB 20.

Referring to FIG. 6, as the MEMS microphone chip 10 is attached to the PCB 20 via the adhesive 20, the vent path 24 is formed in a portion where the adhesive 22 is not applied, so that air may freely flow through the vent path 24. The sound holes 40a are formed in the case 40. The case 40 is adhered to the PCB 20, so that a space for accommodating the MEMS microphone chip 10 and the other circuit devices 30 is formed.

Therefore, in the MEMS microphone package according to the present embodiment, the diaphragm 14 oscillates when external sounds are input via the sound holes 40a formed in the case 40. Here, air inside the MEMS microphone chip 10 (air in the back chamber) and air outside the MEMS microphone chip 10 freely flow in and out not only via the vent holes 14a, but also via the vent path 24. Therefore, a change of sound pressures due to oscillation of the diaphragm 14 may be quickly settled to equilibrium, and thus, the sensitivity and acoustic properties of an MEMS microphone package may be improved.

FIG. 7 shows an example of an MEMS microphone package according to another embodiment of the present invention, where sound holes are formed in a substrate, according to an embodiment of the present invention. In detail, according to the present embodiment, the vent path 24 for forming air pressure equilibrium is formed by applying the adhesive 22 to only portions of surfaces of the PCB 20, in which sound holes 20a are formed, and the MEMS microphone chip 10 to be adhered to each other, and then the case 40 in which no sound hole is formed is adhered to the PCB 20.

Referring to FIG. 7, as the MEMS microphone chip 10 is attached to the PCB 20 via the adhesive 20, the vent path 24 is formed in a portion where the adhesive 22 is not applied, so that air may freely flow through the vent path 24. The sound holes 20a are formed in the PCB 20. The case 40 is adhered to the PCB 20, so that a space for accommodating the MEMS microphone chip 10 and the other circuit devices 30 is formed.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A micro electro machining system (MEMS) microphone package comprising:
a MEMS microphone chip, in which a back plate and a diaphragm structure are formed in a body by using MEMS process techniques;
a substrate for mounting the MEMS microphone chip thereon;
a vent path which is formed between the MEMS microphone chip and the substrate by applying an adhesive only to a portion of the substrate and adhering the MEMS microphone chip to the substrate; and
a case which is adhered to the substrate and forms a space for accommodating the MEMS microphone chip,
wherein acoustic properties of the MEMS microphone package are improved as air pressure inside the MEMS microphone chip and air pressure outside the MEMS microphone chip form air equilibrium via the vent path.

2. The MEMS microphone package of claim 2, wherein sound holes are formed in at least one of the case and the substrate.

3. The MEMS microphone package of claim 1, wherein the substrate is any of a printed circuit board (PCB), a ceramic substrate, and a metal substrate.

4. The MEMS microphone package of claim 1, wherein at least one vent path is formed.

5. A method of packaging a MEMS microphone, the method comprising:
preparing a substrate;
calculating a thickness of an adhesive to be applied to the substrate;
applying the adhesive to a portion of the substrate to the calculated thickness, such that the adhesive is not applied to a portion in which a vent path is to be formed;
adhering an MEMS microphone chip to the adhesive;
drying the adhesive; and
adhering a case to the substrate.

6. The method of claim 5, wherein
the substrate is any of a printed circuit board (PCB), a ceramic substrate, and a metal substrate, and
sound holes are formed in at least one of the case and the substrate.
